(19) Europäisches Patentamt
European Patent Office
Office européen des brevets

(11) **EP 4 388 325 B1**

(12) **EUROPÄISCHE PATENTSCHRIFT**

(45) Veröffentlichungstag und Bekanntmachung des Hinweises auf die Patenterteilung:
**29.04.2026 Patentblatt 2026/18**

(21) Anmeldenummer: **22768306.7**

(22) Anmeldetag: **18.08.2022**

(51) Internationale Patentklassifikation (IPC):
*G01P 21/02* (2006.01)    *G01P 3/487* (2006.01)
*B62J 45/412* (2020.01)    *G01R 33/00* (2006.01)
*G01R 33/028* (2006.01)    *G01R 33/038* (2006.01)

(52) Gemeinsame Patentklassifikation (CPC):
**G01P 3/487; G01P 21/02; G01R 33/0017;**
G01R 33/0283; G01R 33/038

(86) Internationale Anmeldenummer:
**PCT/EP2022/073062**

(87) Internationale Veröffentlichungsnummer:
**WO 2023/021131 (23.02.2023 Gazette 2023/08)**

(54) **VERFAHREN ZUM ERMITTELN EINES FUNKTIONALEN ZUSAMMENHANGS EINER BETRIEBSGRÖSSE EINER ANTRIEBSEINHEIT EINES FAHRZEUG UND EINES STÖRMAGNETFELDES**

METHOD FOR DETERMINING A FUNCTIONAL RELATIONSHIP BETWEEN AN OPERATING VARIABLE OF A DRIVE UNIT OF A VEHICLE AND AN INTERFERING MAGNETIC FIELD

PROCÉDÉ DE DÉTERMINATION D'UNE RELATION FONCTIONNELLE ENTRE UN PARAMÈTRE DE FONCTIONNEMENT D'UNE UNITÉ D'ENTRAÎNEMENT D'UN VÉHICULE ET UN CHAMP MAGNÉTIQUE PARASITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.08.2021 DE 102021209114**
**17.08.2022 DE 102022208535**

(43) Veröffentlichungstag der Anmeldung:
**26.06.2024 Patentblatt 2024/26**

(73) Patentinhaber: **Robert Bosch GmbH**
**70442 Stuttgart (DE)**

(72) Erfinder: **HAU, Julian**
**72768 Reutlingen (DE)**

(56) Entgegenhaltungen:
**EP-A2- 3 435 094    DE-A1- 102017 210 673**
**US-A1- 2019 078 884    US-A1- 2019 353 677**

**Beschreibung**

Die Erfindung betrifft darüber hinaus ein Verfahren zum Bestimmen einer Geschwindigkeit eines einspurigen Fahrzeugs wie ein Pedelec, wobei das Fahrzeug eine elektrische Antriebseinheit, einen Magnetfeldsensor und einen an einem Rad des Fahrzeugs angeordneten Magneten aufweist.

Stand der Technik

Zur Geschwindigkeitsbestimmung von Fahrzeugen ist es bekannt geworden, an einem Rad einen Magneten festzulegen. Bei jeder Umdrehung des Rades wird das Magnetfeld beim Vorbeirotieren beziehungsweise -laufen an einem Magnetfeldsensor von diesem detektiert. Aus dem zeitlichen Abstand aufeinanderfolgender Detektionen durch den Magnetfeldsensor und dem Raddurchmesser kann die Geschwindigkeit des Fahrzeugs berechnet werden.

Insbesondere bei Pedelecs ist der Magnetfeldsensor häufig in der Nähe oder in der Antriebseinheit angeordnet. Aufgrund der Entwicklungen im Pedelec-Sektor steigen die Leistungsdichten der Antriebseinheiten an, während der Bauraum für abschirmende Elemente geringer wird. Damit steigt die Wahrscheinlichkeit, dass ein von der Antriebseinheit, insbesondere von einem Elektromotor, erzeugtes Magnetfeld den Magnetfeldsensor stört. Somit besteht die Möglichkeit, dass der Magnetfeldsensor den vorbeirotierenden Magneten nicht anhand seines Magnetfeldes erkennt, oder ein Magnetfeld erkennt, das in Realität nicht von dem Magneten am Rad erzeugt wird.

Ferner wird auf die Druckschriften DE 10 2017 210673 A1, EP 3 435 094 A2 und US 2019/353677A1 verwiesen.

Offenbarung der Erfindung

Die Erfindung betrifft ein Verfahren zum Bestimmen einer Geschwindigkeit eines einspurigen Fahrzeugs (1) wie ein Pedelec mit den Merkmalen des Anspruchs 1. Vorteilhafte Weiterbildungen ergeben sich aus den abhängigen Ansprüchen.

In einer Ausführungsform stellt die vorliegende Erfindung ein einspuriges Fahrzeug wie ein Pedelec bereit, wobei das Fahrzeug eine elektrische Antriebseinheit, einen Magnetfeldsensor und einen an einem Rad des Fahrzeugs angeordneten Magneten aufweist, umfassend:

- eine Steuereinrichtung, ausgebildet zum Betreiben der elektrischen Antriebseinheit des Fahrzeugs in mehreren Lastpunkten durch Verändern zumindest einer Betriebsgröße wie Stromstärke und/oder Drehzahl,
- eine erste Ermittlungseinrichtung, ausgebildet zum Ermitteln eines funktionalen Zusammenhangs eines bestimmten Störmagnetfeldes mit der zumindest einen Betriebsgröße,
- eine Messeinrichtung, umfassend den Magnetfeldsensor, welche zum Messen eines zeitlichen Verlaufs eines Magnetfelds mittels des Magnetfeldsensors sowie von der zumindest einen Betriebsgröße der Antriebseinheit wie einer Stromstärke der Antriebseinheit und/oder einer Drehzahl der Antriebseinheit ausgebildet ist,
- eine Kompensiereinrichtung, ausgebildet zum Kompensieren des gemessenen zeitlichen Verlaufs des Magnetfelds anhand des funktionalen Zusammenhangs sowie der zumindest einen gemessenen Betriebsgröße der Antriebseinheit,
- eine zweite Ermittlungseinrichtung, ausgebildet zum Ermitteln der Geschwindigkeit des Fahrzeugs anhand des kompensierten zeitlichen Verlaufs des Magnetfelds und insbesondere
- eine Bestimmungseinrichtung, ausgebildet zum Bestimmen des von der Antriebseinheit erzeugten Störmagnetfelds, insbesondere eines durch einen Stator der Antriebseinheit erzeugten Störmagnetfelds, in den mehreren Lastpunkten.

Einer der damit erzielten Vorteile ist, dass Störmagnetfelder der Antriebseinheit auf einfache Weise durch einen funktionalen Zusammenhang beschrieben und darüber hinaus kompensiert werden können. Hierdurch können dann Messwerte, beispielsweise ein zeitlicher Verlauf von Magnetfeldern, plausibilisiert werden. Ein weiterer Vorteil ist, dass die Geschwindigkeit des Fahrzeugs zuverlässig bestimmt werden kann. Insbesondere kann eine Geschwindigkeitsermittlung mittels eines an einem Rad eines Fahrzeugs angeordneten Magneten und einem Sensieren des Vorbeilaufens an einem entsprechenden Sensor zuverlässig erfolgen, selbst wenn eine angrenzende Antriebseinheit das Magnetfeld des Magneten beeinflusst.

Allgemein kann so ein Fahrzeug den funktionalen Zusammenhang zwischen einem gemessenen Magnetfeld und zumindest einer Betriebsgröße der elektrischen Antriebseinheit bestimmen und ausgehend von dem ermittelten Zusammenhang den gemessenen zeitlichen Verlauf des Magnetfeldes kompensieren, sodass eine Geschwindigkeitsmessung genauer durchgeführt werden kann. Es ist ebenfalls möglich, dass der funktionale Zusammenhang zwischen einem gemessenen Magnetfeld und der Betriebsgröße der elektrischen Antriebseinheit unabhängig von dem Fahrzeug bestimmt wird, beispielsweise im Rahmen einer Kalibrierung der Antriebseinheit nach der Produktion und der funktionale Zusammenhang anschließend in der Antriebseinheit gespeichert wird. Von diesem funktionalen Zusammenhang ausgehend kann die Geschwindigkeit eines Fahrzeugs, an dem die Antriebseinheit angeordnet wird, bestimmt werden. Weiter können die Einflüsse der Antriebseinheit auf andere magnetfeldbasierte Sensoren in einem Fahrzeug wie ein Drehmomentsensor kompensiert werden.

Das "Messen eines zeitlichen Verlaufs eines Magnetfelds mittels des Magnetfeldsensors" kann in zumindest einer Richtung erfolgen und/oder ein Messen eines Gesamtmagnetfelds umfassen. Insbesondere wird der zeitliche Verlauf des Magnetfelds in derselben Richtung gemessen wie beim Bestimmen des Störmagnetfelds der Antriebseinheit.

Der Betriff "Magnetfeldsensor" ist im weitesten Sinne zu verstehen. Insbesondere ist jeder Sensor, der durch Magnetfelder beeinflussbar ist, als Magnetfeldsensor im Sinne von Ausführungsformen der Erfindung zu verstehen. Beispielsweise ist ein Drehmomentsensor, der auf einem magnetischen Wirkprinzip beruht, ein Magnetfeldsensor.

Weitere Merkmale, Vorteile und weitere Ausführungsformen der Erfindung sind im Folgenden beschrieben oder werden dadurch offenbar.

Gemäß einer vorteilhaften Weiterbildung der Erfindung wird der funktionale Zusammenhang ermittelt, indem zumindest ein Kennfeld des Störmagnetfelds und der Betriebsgrößen der Antriebseinheit wie der Stromstärke der Antriebseinheit und/oder der Drehzahl der Antriebseinheit erzeugt wird. Ausgehend von den verschiedenen Lastpunkten kann ein Kennfeld erzeugt werden. Mittels des Kennfelds kann ein von der Antriebseinheit in einem bestimmten Lastpunkt erzeugtes Störmagnetfeld auf einfache Weise ermittelt werden. Das Kennfeld kann insbesondere ausgehend von einer anderen Antriebseinheit als der Antriebseinheit des Fahrzeugs bestimmt werden, da vom Aufbau ähnliche Antriebseinheiten ein ähnliches Kennfeld erzeugen.

Gemäß einer vorteilhaften Weiterbildung der Erfindung wird zumindest eine Funktion bestimmt, die das Kennfeld angenähert beschreibt. Durch eine solche Näherungsfunktion, die das Kennfeld beschreibt, kann ein Störmagnetfeld auf einfache Weise berechnet und anschließend kompensiert werden. Insbesondere können auch Störmagnetfelder von Lastpunkten berechnet und kompensiert werden, die in dem Kennfeld nicht direkt erfasst sind, beispielsweise wenn der Lastpunkt zwischen zwei bestimmten Lastpunkten des Kennfelds liegt.

Gemäß einer vorteilhaften Weiterbildung der Erfindung werden Informationen des ermittelten funktionalen Zusammenhangs, insbesondere die zumindest eine Funktion und/oder das zumindest eine Kennfeld, in der Antriebseinheit gespeichert. Ein Vorteil hiervon ist, dass der Zusammenhang, die Funktion und/oder das Kennfeld einmalig bestimmt werden können und anschließend genutzt werden können. Insbesondere kann ein Zusammenhang, ein Kennfeld und/oder eine Funktion ausgehend von einer anderen Antriebseinheit als der Antriebseinheit des Fahrzeugs bestimmt werden und anschließend der Zusammenhang, das Kennfeld und/oder die Funktion in einem Speicher des Fahrzeugs gespeichert werden. Es ist ebenfalls denkbar, dass für jede Antriebseinheit ein eigener funktionaler Zusammenhang erzeugt wird, beispielsweise im Rahmen einer Kalibrierung nach der Produktion und dieser in einem Speicher der Antriebseinheit gespeichert wird. Wenn die Antriebseinheit in einem Fahrzeug angeordnet wird, kann der funktionale Zusammenhang ebenfalls in dem Speicher des Fahrzeugs gespeichert werden.

Gemäß einer vorteilhaften Weiterbildung der Erfindung wird der funktionale Zusammenhang einer Amplitude des Störmagnetfelds und/oder einer Phase des Störmagnetfelds mit einer Stromstärke der Antriebseinheit und/oder einer Drehzahl der Antriebseinheit bestimmt. Das Störmagnetfeld kann abhängig von einer Phase und einer Amplitude beschrieben werden. In diesem Fall können insbesondere zwei Kennfelder und/oder zwei Funktionen ermittelt werden, jeweils in Abhängigkeit von der Amplitude des Kennfelds und der Phase des Kennfelds. Vorteil hiervon ist, dass das Störmagnetfeld genauer bestimmt werden kann.

Gemäß einer vorteilhaften Weiterbildung der Erfindung wird der funktionale Zusammenhang, insbesondere in Form einer Funktion und/oder einem Kennfeld, bestimmt, während die Antriebseinheit in einem Fahrzeug betrieben wird. Ein Vorteil hiervon ist, dass die Funktion/das Kennfeld nicht gespeichert werden muss, sondern diese(s) direkt während der Fahrt erstellt wird. Es ist ebenfalls denkbar, dass die Funktion/das Kennfeld nach der Erzeugung in einem entsprechenden Speicher in dem Fahrzeug und/oder der Antriebseinheit gespeichert wird. Ein Vorteil hiervon ist, dass auf eine Kalibrierung nach der Produktion verzichtet werden kann.

Gemäß einer vorteilhaften Weiterbildung der Erfindung wird der funktionale Zusammenhang, insbesondere in Form einer Funktion und/oder einem Kennfeld, bestimmt, während die Antriebseinheit außerhalb eines Fahrzeugs betrieben wird. Ein Vorteil hiervon ist, dass der funktionale Zusammenhang beispielsweise nach der Produktion bestimmt werden kann. Der funktionale Zusammenhang kann anschließend in der Antriebseinheit gespeichert werden. Somit kann die Antriebseinheit bereits kalibriert beziehungsweise mit einer ermittelten Funktion/Kennfeld ausgeliefert werden.

Gemäß einer vorteilhaften Weiterbildung der Erfindung erfolgt das Kompensieren des gemessenen Verlaufs des Magnetfelds anhand einer Rotorlage der Antriebseinheit. In einer elektrischen Antriebseinheit können magnetische Störfelder durch einen Stator und/oder durch einen Rotor entstehen. Die Störfelder durch den Rotor sind abhängig von der Drehzahl des Rotors und der Rotorlage. Somit kann ein Kennfeld erzeugt werden, das einen Zusammenhang der Drehzahl des Rotors, der Rotorlage und des resultierenden Störmagnetfelds beschreibt. Ausgehend von diesem Zusammenhang kann ein detektiertes Magnetfeld kompensiert werden. Dabei kann das Kennfeld, insbesondere durch Modulation der Lastpunkte in dem Fahrzeug erzeugt werden. Ein Vorteil hiervon ist, dass weitere Störfelder kompensiert werden können.

Gemäß einer vorteilhaften Weiterbildung der Erfindung umfasst das Ermitteln der Geschwindigkeit ein Erkennen einer Flanke im zeitlichen Verlauf des gemessenen Magnetfelds. Ein Vorteil hiervon ist, dass auf zuverlässige Weise detektiert werden kann, ob der Magnet an dem Magnetfeldsensor vorbeirotiert. Insbesondere können Störungen des gemessenen Magnetfelds, die ein fehlerhaftes Detektieren des Magneten hervorrufen können, kompensiert werden.

Gemäß einer vorteilhaften Weiterbildung der Erfindung umfasst das Erkennen einer Flanke die Schritte:

- Ermitteln von Hoch- und Tiefpunkten im zeitlichen Verlauf des Magnetfelds,
- Ermitteln einer Flanke anhand der zeitlichen Abfolge eines Hoch- und Tiefpunkts, und
- Vergleichen der Amplitude der ermittelten Flanke mit zumindest einem Schwellwert, wobei die ermittelte Flanke als erkannt gilt, wenn die Amplitude der ermittelten Flanke größer ist als ein erster kleinerer Schwellwert und/oder größer ist als ein zweiter größerer adaptiver Schwellwert.

Einer der damit erzielten Vorteile ist, dass eine robuste und gleichzeitig zuverlässige Erzeugung eines Zeitsignals zur Ermittlung einer Geschwindigkeit des Fahrzeugs ermöglicht wird. Gleichzeitig wird die Flexibilität erhöht, da größere Toleranzen bei der Anordnung von Sensor und Magnet ermöglicht werden, was zudem die Herstellungskosten und den Zeitaufwand für die Montage reduziert. Ein adaptiver Schwellwert ist insbesondere ein Schwellwert, der während einer Fahrt geändert werden kann, beispielsweise anhand von ermittelten Flanken.

Gemäß einer vorteilhaften Weiterbildung der Erfindung werden vor dem Erkennen der Flanke, die Werte des gemessenen Magnetfelds aufbereitet, insbesondere gefiltert, vorzugsweise mittels eines Bandpassfilters, wobei insbesondere ein Sperrund Durchlassbereich des Bandpassfilters an eine vorgegebene Umdrehungsfrequenz des Rades des Fahrzeugs anpasst wird. Vorteil hiervon ist, dass damit beispielsweise Ausreißer oder dergleichen herausgefiltert werden können, was die Zuverlässigkeit der Erkennung von Flanken verbessert.

Gemäß einer vorteilhaften Weiterbildung der Erfindung wird bei Erkennen einer Flanke ein Zeitstempel erzeugt und/oder ein Zähler erhöht. Ein Vorteil hiervon ist, dass auf einfache Weise der zeitliche Abstand zwischen zwei Flanken bestimmt werden kann, sodass davon ausgehend die Geschwindigkeit des Fahrzeugs bestimmt werden kann.

Gemäß einer vorteilhaften Weiterbildung der Erfindung wird das Magnetfeld in mindestens zwei Raumrichtungen gemessen und wobei die in mindestens zwei Raumrichtungen gemessenen Werte des Magnetfeldes vor dem Erkennen einer Flanke in eine Hauptachse der Magnetfelder rotiert werden, insbesondere wobei der Winkel der Hauptachse für die Rotation anhand von Werten des Magnetfeldes in einer zweiten Raumrichtung bestimmt wird. Unter "Raumrichtung" ist synonym eine "Raumachse" zu verstehen. Damit wird die Nutzamplitude für die Erkennung von Flanken erhöht, was insgesamt die Zuverlässigkeit weiter verbessert.

Gemäß einer vorteilhaften Weiterbildung der Erfindung wird zusätzlich ein zeitlicher Verlauf eines Vektors des Magnetfelds ausgewertet, zur Auswertung der steigenden und/oder fallenden Flanken, insbesondere zu deren Plausibilisierung. Vorteil hiervon ist, dass damit die Flankenerkennung noch weiter verbessert wird.

Gemäß einer vorteilhaften Weiterbildung der Erfindung wird anhand der ermittelten Flanke eine mögliche Geschwindigkeit berechnet und die Flanke wird anhand zumindest einer der folgenden Bedingungen mittels eines Plausibilisierungsverfahrens plausibilisiert:

- Wenn die mögliche Geschwindigkeit oberhalb eines vorgebbaren Schwellwerts liegt, wird die ermittelte Flanke verworfen.
- Wenn der Gradient der ermittelten Flanke unterhalb eines Schwellwerts liegt, wird die ermittelte Flanke verworfen.
- Wenn die Zeitdifferenz zwischen dem Tiefpunkt der ermittelten Flanke und dem Zeitpunkt des Überschreitens eines Schwellwerts in dem Flankenverlauf oberhalb eines vorgebbaren Schwellwerts ist, wird die ermittelte Flanke verworfen.
- Wenn die Fahrzeugbeschleunigungen, berechnet aus einer aktuell ermittelten Flanke und einer früheren Flanke, oberhalb eines vorgebbaren Schwellwerts liegen, wird die aktuell ermittelte Flanke verworfen.

Hierdurch wird die Robustheit des Verfahrens verbessert, da mögliche erkannte Flanken plausibilisiert werden. Beispielsweise können Flanken verworfen werden, die eine unrealistisch hohe Geschwindigkeit des Fahrzeugs implizieren würden.

Gemäß einer vorteilhaften Weiterbildung der Erfindung umfasst das Plausibilisierungsverfahren eine Flankenvorhersage, insbesondere anhand von Beschleunigungsdaten des Fahrzeugs, sodass eine erkannte Flanke als unplausibel verworfen wird, wenn anhand der Beschleunigungsdaten keine Flanke vorhergesagt wird. Damit kann die Zuverlässigkeit der Flankenerkennung verbessert werden.

Gemäß einer vorteilhaften Weiterbildung der Erfindung wird zur Erkennung der Polarisierung des Magneten eine vorgebbare Anzahl von ermittelten Flanken und wird insbesondere ein Winkelverlauf des Magnetfeldvektors ermittelt, wobei die Polarisierung anhand eines Vergleichs von maximaler Amplitude der steigenden und der fallenden Amplitude ermittelt wird, wobei wenn die maximale fallende Amplitude größer ist als die maximale steigende Amplitude die Polarisierung des Magneten umgekehrt angenommen wird und die gemessenen Werte des Magnetfelds invertiert werden, wobei die Polarisierung insbesondere anhand einer vorgebbaren Anzahl von steigenden und/oder fallenden Flanken ausgewertet wird. Beim Einbau des Magneten könnte der Magnet um 180° gedreht eingebaut sein. Hierdurch kehrt sich die Polarität des Magneten um. Dies kann anhand des Verlaufs der Flanken erkannt werden. Vorteil hiervon ist, dass die der Magnet in beiden Richtungen eingebaut werden kann.

Gemäß einer vorteilhaften Weiterbildung der Erfindung ist die erste Ermittlungseinrichtung dazu ausgebildet, den funktionalen Zusammenhang aus einem Speicher des Fahrzeugs, insbesondere einem Speicher der Antriebseinheit, zu ermitteln. Ein Vorteil hiervon ist, dass der funktionale Zusammenhang in dem Fahrzeug abgespeichert sein kann und somit eine erneute Bestimmung entfallen kann. Insbesondere kann in der Antriebseinheit bereits bei einer Anordnung an dem Fahrzeug der funktionale Zusammenhang gespeichert sein. Somit kann auf ein Bestimmen des funktionalen Zusammenhangs durch das Fahrzeug verzichtet werden.

Weitere wichtige Merkmale und Vorteile der Erfindung ergeben sich aus den Unteransprüchen, aus den Zeichnungen und aus der dazugehörigen Figurenbeschreibung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungen und Ausführungsformen der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile oder Elemente beziehen.

Dabei zeigt in schematischer Form

Fig. 1    Schritte eines Verfahrens gemäß einer Ausführungsform der vorliegenden Erfindung,

Fig. 2    Schritte eines Verfahrens gemäß einer weiteren Ausführungsform der vorliegenden Erfindung,

Fig. 3    einen Verlauf eines kompensierten Magnetfelds gemäß einer Ausführungsform der vorliegenden Erfindung,

Fig. 4    ein Kennfeld gemäß einer Ausführungsform der vorliegenden Erfindung,

Fig. 5    einen Verlauf eines Magnetfelds mit erkannten Flanken gemäß einer Ausführungsform der vorliegenden Erfindung,

Fig. 6    einen Teil eines einspurigen Fahrzeugs gemäß einer Ausführungsform der vorliegenden Erfindung, und

Fig. 7    ein einspuriges Fahrzeug gemäß einer Ausführungsform der vorliegenden Erfindung.

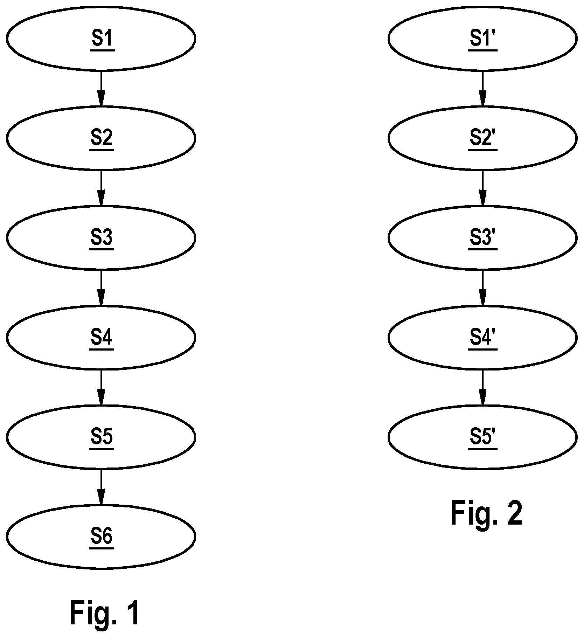

Figur 1 zeigt in schematischer Form Schritte eines Verfahrens gemäß einer Ausführungsform der vorliegenden Erfindung.

Figur 1 zeigt Schritte eines Verfahrens zur Bestimmung einer Geschwindigkeit eines einspurigen Fahrzeugs, wobei das Fahrzeug eine elektrische Antriebseinheit, einen Magnetfeldsensor und einen an einem Rad des Fahrzeugs angeordneten Magneten aufweist.

In einem Schritt S1 wird eine elektrische Antriebseinheit in mehreren Lastpunkten durch Verändern von zumindest einer Betriebsgröße der Antriebseinheit wie Stromstärke und/ oder Drehzahl betrieben. Bei der elektrischen Antriebseinheit kann es sich um die Antriebseinheit des Fahrzeugs oder eine Testantriebseinheit handeln. Diese wird in verschiedenen Lastpunkten betrieben, das heißt, dass Betriebsgrößen der Antriebseinheit, beispielsweise die Stromstärke und die Drehzahl, in diskreten Schritten verändert wird.

In einem weiteren Schritt S2 wird ein von der Antriebseinheit erzeugtes Störmagnetfeld, insbesondere ein durch einen Stator der Antriebseinheit erzeugtes Störmagnetfeld, in den mehreren Lastpunkten bestimmt. Für jeden Lastpunkt wird das von der Antriebseinheit erzeugte Magnetfeld bestimmt. Insbesondere wird die Amplitude und die Phase des Magnetfelds bestimmt. Diese können beispielsweise jeweils in Zusammenhang mit der Stromstärke und der Drehzahl in ein Kennfeld eingetragen werden. Die Phase des Magnetfelds wird beispielsweise auf den Winkel des Stromzeigers bezogen. Der Winkel des Stromzeigers wird anhand der Formel

$$\varphi_0 = atan2\left(I_\beta, I_\alpha\right)$$

bestimmt.

Dabei ist

$\varphi_0$: Der Winkel des Stromzeigers im Stator
$I_\beta$, $I_\alpha$: Die Statorströme in $\alpha$, $\beta$ - Koordinaten

In einem weiteren Schritt S3 wird ein funktionaler Zusammenhang des bestimmten Störmagnetfeldes mit der zumindest einen Betriebsgröße der Antriebseinheit ermittelt. Es ist möglich, dass das Störmagnetfeld anhand der Amplitude und der Phase bestimmt wird. In diesem Fall können zwei funktionale Zusammenhänge bestimmt werden. Erstens der Zusammenhang zwischen der Amplitude des Magnetfelds und den Betriebsgrößen und zweitens der Zusammenhang zwischen der Phase des Magnetfelds und den Betriebsgrößen. Die funktionalen Zusammenhänge können beispielsweise mittels Kennfeldern ermittelt werden. Insbesondere werden Funktionen berechnet, die möglichst genau die Punkte in dem Kennfeld beschreiben. Auf diese Weise erhält man zwei Funktionen, mit denen man für beliebige Lastpunkte die Magnetfeldamplitude und -phase berechnen kann. Diese Funktionen werden in dem Fahrzeug oder in der Antriebseinheit gespeichert.

In einem weiteren Schritt S4 wird ein zeitlicher Verlauf eines Magnetfelds mittels des Magnetfeldsensors und der zumindest einen Betriebsgröße der Antriebseinheit wie eine Stromstärke der Antriebseinheit und/oder eine Drehzahl der Antriebseinheit gemessen. Der zeitliche Verlauf des Magnetfelds wird von dem Magnetfeldsensor des Fahrzeugs gemessen und kann somit durch das Störmagnetfeld der Antriebseinheit beeinflusst sein. Mit anderen Worten entspricht der zeitliche Verlauf des gemessenen Magnetfelds nicht lediglich dem zeitlichen Verlauf des durch den Magneten erzeugten Magnetfeldes.

Deswegen wird in einem weiteren Schritt S5 der gemessene zeitliche Verlauf des Magnetfelds anhand des funktionalen Zusammenhangs sowie der zumindest einen gemessenen Betriebsgröße der Antriebseinheit kompensiert. Die Betriebsgrö-ßen wie die Stromstärke und die Drehzahl der Antriebseinheit sind aus Schritt S4 bekannt, sodass ausgehend von der in Schritt S3 ermittelten Funktion, das Störmagnetfeld der Antriebseinheit ermittelt werden kann. Die ermittelte Störung des Magnetfelds wird von dem gemessenen Magnetfeld subtrahiert, sodass das resultierende Magnetfeld dem tatsächlichen Magnetfeld des Magneten entspricht. Das kompensierte Magnetfeld kann beispielsweise anhand folgender Formeln berechnet werden:

$$Mag_{komp} = Mag_{Sensor} - Mag_{Antrieb}$$

$$Mag_{Antrieb} = A * \cos(\varphi_0 - \varphi)$$

Dabei ist:

$Mag_{komp}$: *Das kompensierte Magnetfeld*
$Mag_{Sensor}$: *Das vom Magnetfeldsensor ermittelte Magnetfeld*
$Mag_{Antrieb}$: *Das von der Antriebseinheit erzeugte Störmagnetfeld*
$A$: *Die Amplitude des von der Antriebseinheit erzeugten Magnetfelds*
$\varphi$: *Die Phase des von der Antriebseinheit erzeugten Magnetfelds bezogen auf den Winkel des Stromzeigers*
$\varphi_0$: *Der Winkel des Stromzeigers im Stator*

Da der Verlauf des gemessenen Magnetfelds um die Störeinflüsse bereinigt ist und im Wesentlichen dem Verlauf des Magnetfelds des Magneten entspricht, kann in einem weiteren Schritt S6 davon ausgehend die Geschwindigkeit des Fahrzeugs bestimmt werden.

Figur 2 zeigt in schematischer Form Schritte eines Verfahrens gemäß einer weiteren Ausführungsform der vorliegenden Erfindung.

Figur 2 zeigt Schritte eines Verfahren zum Plausibilisieren von Messwerten eines Magnetfeldsensors in einem Fahrzeug, insbesondere einem einspurigen Fahrzeug wie ein Pedelec, durch Kompensieren von Störmagnetfeldern einer elektrischen Antriebseinheit des Fahrzeugs.

Mit dem Verfahren gemäß den Schritten S1 bis S5 nach Figur 1 kann insbesondere ein zur Bestimmung einer Geschwindigkeit genutzter Magnetfeldsensor um Störungen bereinigt werden. Es ist jedoch ebenfalls möglich, dass andere magnetfeldbasierte Sensoren, beispielsweise ein Drehmomentsensor, durch die elektrische Antriebseinheit des Fahrzeugs gestört werden. Diese Störung kann ebenfalls kompensiert werden.

Insbesondere können die Störung anhand der folgenden Schritte kompensiert werden, sodass Messwerte des Magnetfeldsensors plausibilisiert werden:

- Betreiben S1' einer elektrischen Antriebseinheit, insbesondere der elektrischen Antriebseinheit des Fahrzeugs, in mehreren Lastpunkten durch Verändern von zumindest einer Betriebsgröße wie Stromstärke und/oder Drehzahl,
- Bestimmen S2' eines von der Antriebseinheit erzeugten Störmagnetfelds, insbesondere eines durch einen Stator der Antriebseinheit erzeugten Störmagnetfelds, in den mehreren Lastpunkten,
- Ermitteln S3' eines funktionalen Zusammenhangs des bestimmten Störmagnetfeldes mit der zumindest einen Betriebsgröße der Antriebseinheit,
- Messen S4' eines zeitlichen Verlaufs eines Magnetfelds mittels des Magnetfeldsensors und von der zumindest einen Betriebsgröße der Antriebseinheit wie einer Stromstärke der Antriebseinheit und/oder einer Drehzahl der Antriebseinheit,
- Kompensieren S5' des gemessenen zeitlichen Verlaufs des Magnetfelds anhand des funktionalen Zusammenhangs sowie der zumindest einen gemessenen Betriebsgröße der Antriebseinheit.

Die Schritte S1' bis S5' können dabei insbesondere den Schritten S1 bis S5 gemäß Figur 1 entsprechen.

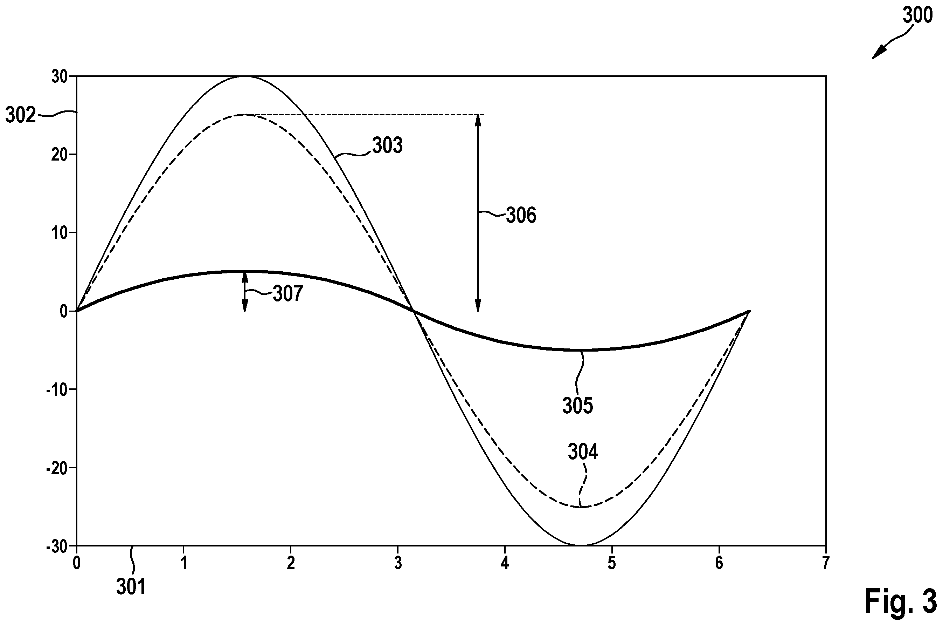

Figur 3 zeigt in schematischer Form einen Verlauf eines kompensierten Magnetfelds gemäß einer Ausführungsform der vorliegenden Erfindung.

Das Diagramm 300 zeigt den Verlauf eines von einem Magnetfeldsensor (nicht gezeigt) gemessenen Magnetfelds 303, eines von einer Antriebseinheit (nicht gezeigt) erzeugtem Störmagnetfeld 304 und eines kompensierten Magnetfelds 305. Die X-Achse 301 zeigt den Winkel des Stromzeigers in Radianten und die Y-Achse die magnetische Flussdichte in $\mu$T.

Das kompensierte Magnetfeld 305 entspricht der Differenz des von dem Magnetfeldsensor gemessenen Magnetfeld 303 und dem von der Antriebseinheit erzeugt Störmagnetfeld 304. Aufgrund von beispielsweise Messungenauigkeiten ist es möglich, dass das Störmagnetfeld nicht komplett kompensiert werden kann und ein Anteil der Störung im kompensierten Magnetfeld 305 verbleibt. Ausgehend von dem kompensierten Magnetfeld 305 kann beispielsweise die Geschwindigkeit eines Fahrzeugs bestimmt werden.

Die Amplitude 306 des Störmagnetfelds 304 kann größer sein als die Amplitude des von einem vorbeirotierenden Magneten erzeugten Magnetfelds und insbesondere größer als die Amplitude 307 des kompensierten Magnetfeldes 305. Das heißt, dass beispielsweise bei einem magnetfeldbasierten Geschwindigkeitssensor die Antriebseinheit ein derart starkes Magnetfeld generieren könnte, dass der Geschwindigkeitssensor ein Vorbeirotieren des Magneten detektiert, obwohl der an einem Rad eines Fahrzeugs angeordnete Magnet sich nicht in der Nähe des Magnetfeldsensors befindet. Durch die Kompensation wird der Einfluss der Antriebseinheit vermindert.

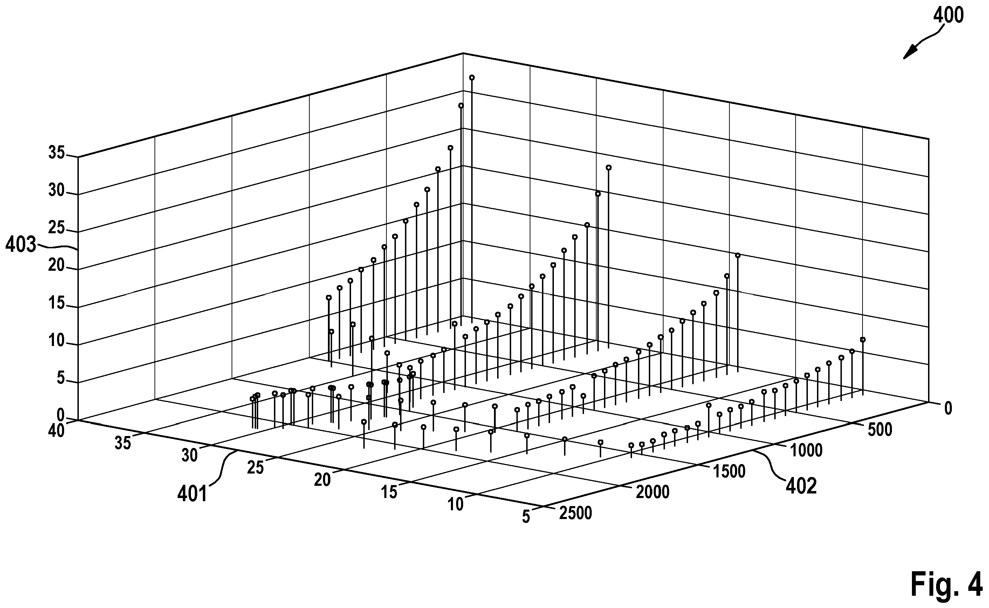

Figur 4 zeigt in schematischer Form ein Kennfeld gemäß einer Ausführungsform der vorliegenden Erfindung.

Das Diagramm 400 zeigt ein Kennfeld einer Antriebseinheit eines Fahrzeugs (nicht gezeigt). Das Kennfeld kann beispielsweise durch Ausführen der Schritte S1 und S2 gemäß Figur 1 erzeugt werden. Insbesondere wird die Antriebseinheit in verschiedenen Lastpunkten gefahren und jeweils die Stromstärke, die Drehzahl und das Störmagnetfeld gemessen. Die daraus resultierenden Wertepaare können dann in das Kennfeld eingetragen werden.

Die X-Achse 401 zeigt hierbei die Stromstärke in Ampere, die Y-Achse 402 zeigt die Motordrehzahl in Umdrehungen pro Minute und die Z-Achse 403 zeigt die magnetische Flussdichte in $\mu$T.

Aus dem Kennfeld kann ein Zusammenhang zwischen der Stromstärke, der Drehzahl und der magnetischen Flussdichte ermittelt werden. Beispielsweise ist zu erkennen, dass bei steigender Drehzahl und konstanter Stromstärke sich die magnetische Flussdichte verringert. Gleichzeitig ist zu erkennen, dass sich die magnetische Flussdichte bei konstanter Drehzahl und steigender Stromstärke erhöht.

Dieser Zusammenhang kann durch eine mathematische Funktion beschrieben werden. Die Funktion erlaubt es somit zu einer beliebigen Kombination aus Drehzahl und Stromstärke die resultierende Magnetfeldamplitude - also die Stärke des Störmagnetfelds - zu bestimmen. Dabei ist insbesondere der Unterschied zwischen einer aus dem Kennfeld ermittelten magnetischen Flussdichte und einer korrespondierenden, durch die Funktion berechneten magnetischen Flussdichte in jedem Lastpunkt möglichst gering, sodass die Funktion das Kennfeld möglichst genau beschreibt.

Diese Funktion kann anschließend in einem Speicher des Fahrzeugs gespeichert werden, in dem die Antriebseinheit angeordnet ist. Es ist ebenfalls möglich, dass die Funktion in einem Speicher eines weiteren Fahrzeugs gespeichert wird, das eine der Antriebseinheit vom Aufbau ähnliche Antriebseinheit aufweist. Weiter ist es möglich, dass die Funktion in einem Speicher der Antriebseinheit gespeichert wird, beispielsweise wenn die Antriebseinheit noch nicht an einem Fahrzeug angeordnet ist.

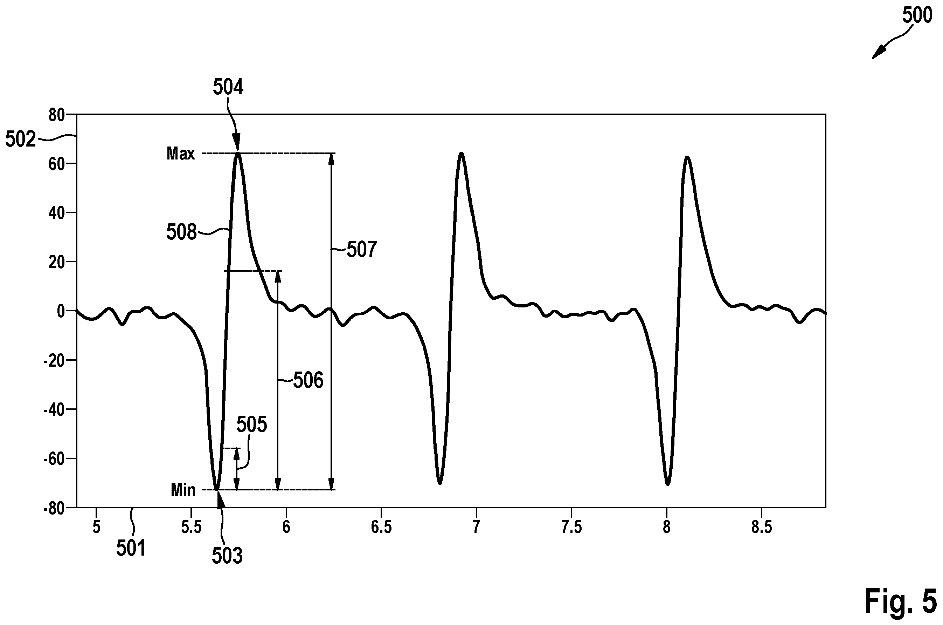

Figur 5 zeigt einen Verlauf eines Magnetfelds mit erkannten Flanken gemäß einer Ausführungsform der vorliegenden Erfindung.

Das Diagramm 500 zeigt einen zeitlichen Verlauf von Werten eines Magnetfeldsensors (nicht gezeigt). Die X-Achse 501 zeigt die Zeit in Sekunden und die Y-Achse 502 die magnetische Flussdichte in $\mu$T.

Zur Geschwindigkeitsbestimmung eines Fahrzeugs mit einer elektrischen Antriebseinheit, einem Magnetfeldsensor und einem an einem Rad des Fahrzeugs angeordneten Magneten können beispielsweise die Schritte S1 bis S6 gemäß Figur 1 durchgeführt werden. In Schritt S6 gemäß Figur 1 wird die Geschwindigkeit anhand des Verlaufs des kompensierten Magnetfelds ermittelt. Beispielsweise kann die Geschwindigkeit durch den zeitlichen Abstand von Magnetfeldspitzen im Verlauf des kompensierten Magnetfelds bestimmt werden. Durch die Kompensierung werden Störeinflüsse der Antriebseinheit reduziert. Jedoch kann das kompensierte Magnetfeld durch weitere Magnetfelder beeinflusst sein, sodass ein korrektes Erkennen von Magnetfeldspitzen im Verlauf des kompensierten Magnetfelds möglicherweise erschwert ist.

Zur robusten Geschwindigkeitsbestimmung können Flanken im kompensierten Magnetfeld erkannt werden. Zunächst werden in dem zeitlichen Verlauf des kompensierten Magnetfelds Hoch- 504 und Tiefpunkte 503 detektiert. Eine Flanke 508 im zeitlichen Verlauf des Magnetfeldes wird daran erkannt, dass auf einen Tiefpunkt 503 ein Hochpunkt 504 folgt. Dabei muss die Amplitude 507 zwischen Tiefpunkt 503 und Hochpunkt 504 größer als ein erster Schwellwert 505, insbesondere größer als ein adaptiver zweiter Schwellwert 506, sein. Durch den zeitlichen Abstand zweier Flanken 508 kann die Geschwindigkeit bestimmt werden. Hierfür wird für jede erkannte Flanke ein Zeitstempel erzeugt.

Wenn auf einen Hochpunkt 504 ein Tiefpunkt 503 folgt, wird keine Flanke erkannt.

Dies kann jedoch ein Hinweis sein, dass die Polarisierung des Magneten umgekehrt ist.

Anschließend können die erkannten Flanken 508 plausibilisiert werden, um zu überprüfen, ob eine erkannte Flanke 508 plausibel ist. Insbesondere wenn eine Flanke 508 größer als der erste Schwellwert 505 aber kleiner als ein zweiter Schwellwert 506 ist, kann die Flanke 508 plausibilisiert werden. Wenn eine Flanke 508 als unplausibel erkannt wird, wird die Flanke 508 verworfen und nicht zur Bestimmung der Geschwindigkeit herangezogen. Der zweite adaptive Schwellwert kann individuell eingelernt werden. Beispielsweise können bei einer Fahrt plausible vollständige Flanken genutzt werden, um den zweiten adaptiven Schwellwert zu definieren. Insbesondere kann der zweite Schwellwert erhöht werden, wenn eine bestimmte Anzahl an Flanken eine größere Amplitude als der zweite Schwellwert aufweisen.

Zur Plausibilisierung wird die Geschwindigkeit anhand zweier aufeinanderfolgenden Flanken 508 berechnet. Wenn die Geschwindigkeit zu hoch ist, als dass sie realistisch mit dem Fahrzeug erreicht werden kann, wird die Flanke 508 verworfen. Je schneller das Fahrzeug fährt, desto steiler sind die Flanken 508 im Verlauf des Magnetfeldsensors. Wenn die Steigung der Flanke 508 nicht zu der berechneten Geschwindigkeit passt, wird die Flanke 508 verworfen. Außerdem kann eine Flanke 508 verworfen werden, wenn der Unterschied von zwei aufeinanderfolgenden Geschwindigkeiten nicht zu der erwarteten Beschleunigung des Fahrzeugs passt. Weiterhin kann die Flanke 508 verworfen werden, wenn nach dem Tiefpunkt 503 nicht schnell genug der erste Schwellwert erreicht wird.

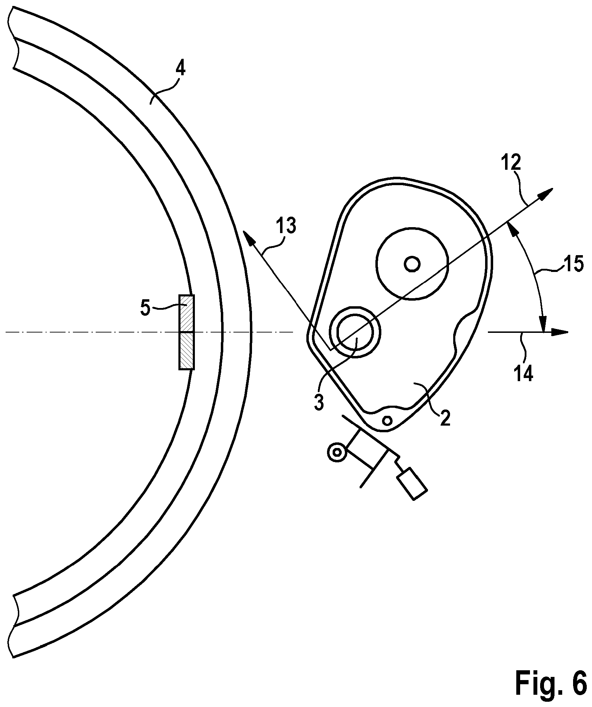

Figur 6 zeigt in schematischer Form einen Teil eines einspurigen Fahrzeugs gemäß einer Ausführungsform der vorliegenden Erfindung.

Wie in Bezug auf Figur 5 beschrieben, können Flanken in dem kompensierten zeitlichen Verlauf des Magnetfelds erkannt werden und davon ausgehen die Geschwindigkeit eines Fahrzeugs ermittelt werden. Um das Erkennen von Flanken zu erleichtern kann der kompensierte Verlauf des Magnetfelds vor dem Erkennen der Flanken verändert werden.

Um kleine Sprünge innerhalb des kompensierten zeitlichen Verlaufs des Magnetfelds zu verringern kann dieser zunächst gefiltert werden, beispielsweise mit einem Bandpassfilter.

Die Anordnung des Magnetfeldsensors 3 kann den kompensierten zeitlichen Verlaufs des Magnetfelds beeinflussen. Ein Magnetfeldsensor 3 ist hier an einer Antriebseinheit 2 in der Nähe von einem Rad 4 eines Fahrzeugs (nicht gezeigt) angeordnet. An dem Rad 4 ist ein Magnet 5 angeordnet. Durch den Magneten 5 wird ein Magnetfeld erzeugt, das von dem Magnetfeldsensor 3 detektiert werden kann, wenn sich dieser in der Nähe des Sensors vorbei bewegt. Dabei befindet sich der größte Signalhub von dem erzeugten Magnetfeld in der Hauptachse 14, da der Magnet beim Überqueren der Hauptachse 14 den geringsten Abstand zum Magnetfeldsensor 3 aufweist und gleichzeitig senkrecht zur Hauptachse 14 ausgerichtet ist. Bei der Montage des Magnetfeldsensors 3 ist es möglich, dass die Antriebseinheit 2 und somit der Magnetfeldsensor 3 schräg zur Hauptachse 14 angeordnet wird. Der Magnetfeldsensor 3 kann das Magnetfeld in zumindest einer Messrichtung 12, vorzugsweise in zwei Messrichtungen 12, 13 messen. Wenn die Antriebseinheit 2 und somit der Magnetfeldsensor 3 verdreht angeordnet sind, verdrehen sich die Messrichtungen 12, 13 des Magnetfeldsensors 3, sodass keine der Messrichtungen 12, 13 parallel zur Hauptachse 14 liegen. In diesem Fall wird die nutzbare Amplitude des Magnetfelds und damit der Signalhub verringert.

Deswegen wird das Magnetfeld in zumindest zwei Raumrichtungen 12, 13 gemessen. Ausgehend von dem Magnetfeld in den zwei Raumrichtungen 12, 13 kann der Winkel 15 gemessen werden, um den der Magnetfeldsensor 3 verdreht ist. Mithilfe des Winkels 15 können die Werte des zeitlichen Verlaufs des in den zwei Messrichtungen 12, 13 gemessenen kompensierten Magnetfelds in die Hauptachse 14 gedreht werden, sodass die nutzbare Amplitude des Magnetfelds erhöht wird. Hierdurch wird das Erkennen der Flanken erleichtert.

Des Weiteren kann der Magnet 5 beispielsweise um 180° gedreht an dem Rad 4 angeordnet sein. In dem Fall ist die Polarisierung des Magneten 5 umgekehrt. Bei einem nicht um 180° gedrehten Magneten sinkt die Amplitude zunächst und steigt anschließend stark an. Bei einem gedrehten Magneten ist dies umgekehrt. Mit anderen Worten folgt in dem zeitlichen Verlauf des Magnetfelds gemäß Figur 5 auf einen Hochpunkt 504 ein Tiefpunkt 503. Hieran kann die Polarisierung des Magneten erkannt werden. Wenn erkannt wird, dass der Magnet mit umgekehrter Polarisierung angeordnet ist, kann der zeitliche Verlauf des kompensierten Magnetfelds invertiert werden, sodass eine korrekte Polarisierung des Magneten simuliert wird.

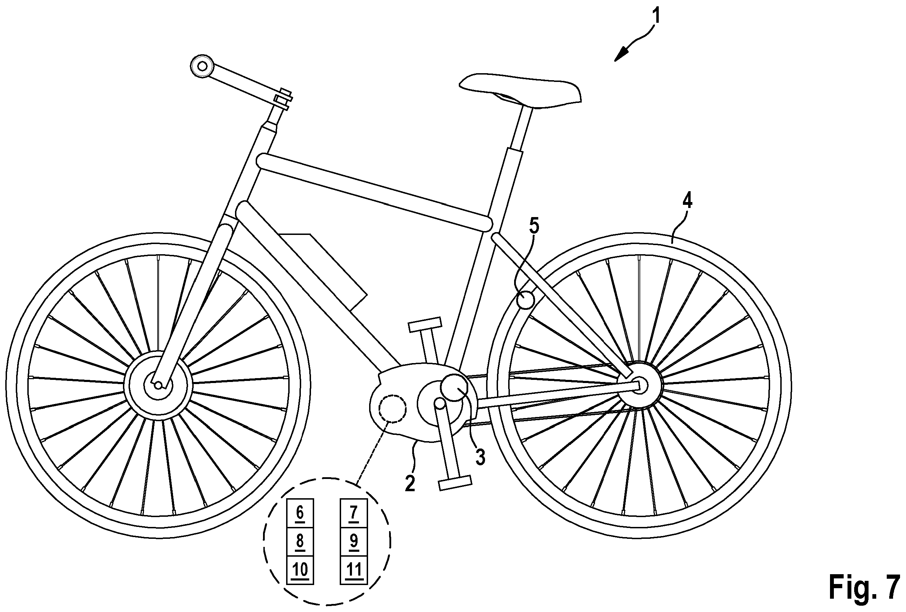

Figur 7 zeigt in schematischer Form ein einspuriges Fahrzeug gemäß einer Ausführungsform der vorliegenden Erfindung.

Das Fahrzeug 1, hier in Form eines Pedelecs, weist eine elektrische Antriebseinheit 2, einen Magnetfeldsensor 3 und einen an einem Rad 4 des Fahrzeugs 1 befestigten Magneten 5 auf. Weiter umfasst das das Fahrzeug 1:

- eine Steuereinrichtung 6, ausgebildet zum Betreiben der elektrischen Antriebseinheit 2 des Fahrzeugs 1 in mehreren Lastpunkten durch Verändern zumindest einer Betriebsgröße wie Stromstärke und/oder Drehzahl,
- eine erste Ermittlungseinrichtung 8, ausgebildet zum Ermitteln eines funktionalen Zusammenhangs eines bestimmten Störmagnetfeldes mit der zumindest einen Betriebsgröße,
- eine Messeinrichtung, umfassend den Magnetfeldsensor, welche zum Messen eines zeitlichen Verlaufs eines Magnetfelds mittels des Magnetfeldsensors 3 sowie von der zumindest einen Betriebsgröße der Antriebseinheit 2 wie einer Stromstärke der Antriebseinheit 2 und/oder einer Drehzahl der Antriebseinheit 2 ausgebildet ist,
- eine Kompensiereinrichtung 10, ausgebildet zum Kompensieren des gemessenen zeitlichen Verlaufs des Magnetfelds anhand des funktionalen Zusammenhangs sowie der zumindest einen gemessenen Betriebsgröße der Antriebseinheit 2,
- eine zweite Ermittlungseinrichtung 11, ausgebildet zum Ermitteln der Geschwindigkeit des Fahrzeugs 1 anhand des kompensierten zeitlichen Verlaufs des Magnetfelds und insbesondere
- eine Bestimmungseinrichtung 7, ausgebildet zum Bestimmen des von der Antriebseinheit 2 erzeugten Störmagnetfelds, insbesondere eines durch einen Stator der Antriebseinheit 2 erzeugten Störmagnetfelds, in den mehreren Lastpunkten.

Die Bestimmungseinrichtung 7 kann das von der Antriebseinheit erzeugte Störmagnetfeld bestimmen, sodass hiervon ausgehend mittels der ersten Ermittlungseinrichtung 8 der funktionale Zusammenhang bestimmt werden kann. Wenn die Antriebseinheit 2 bereits mit einem gespeicherten funktionalen Zusammenhang, beispielsweise einem Kennfeld und/oder einer Funktion, an dem Fahrzeug angeordnet worden ist, kann die Bestimmungseinrichtung 7 entfallen.

Das Fahrzeug ist insbesondere ausgebildet die Schritte S1 bis S6 gemäß Figur 1, sowie die Schritte S1' bis S5' gemäß Figur 2 durchzuführen.

Obwohl die vorliegende Erfindung anhand bevorzugter Ausführungsbeispiele beschrieben wurde, ist sie nicht darauf beschränkt, sondern auf vielfältige Weise modifizierbar. Die vorliegende Erfindung ist durch die unabhängigen Ansprüche definiert, und vorteilhafte Ausführungsformen werden in den abhängigen Ansprüchen beschrieben.

**Patentansprüche**

1. Verfahren zum Bestimmen einer Geschwindigkeit eines einspurigen Fahrzeugs (1) wie ein Pedelec, wobei das Fahrzeug (1) eine elektrische Antriebseinheit (2), einen Magnetfeldsensor (3) und einen an einem Rad (4) des Fahrzeugs (1) angeordneten Magneten (5) aufweist, wobei der Magnetfeldsensor dazu eingerichtet ist, das Magnetfeld des Magneten bei Vorbeirotieren am Magnetfeldsensor zu detektieren, wobei das Verfahren durch die folgenden Schritte gekennzeichnet ist:

   - Betreiben (S1) der elektrischen Antriebseinheit (2) in mehreren Lastpunkten durch Verändern von zumindest einer Betriebsgröße wie Stromstärke und/oder Drehzahl,
   - Bestimmen (S2) eines von der Antriebseinheit (2) erzeugten Störmagnetfelds (304), insbesondere eines durch einen Stator der Antriebseinheit (2) erzeugten Störmagnetfelds (304), in den mehreren Lastpunkten,
   - Ermitteln (S3) eines funktionalen Zusammenhangs des bestimmten Störmagnetfeldes (304) mit der zumindest einen Betriebsgröße der Antriebseinheit (2)
   - Messen (S4) eines zeitlichen Verlaufs eines Magnetfelds (303) mittels des Magnetfeldsensors (3) und von der zumindest einen Betriebsgröße der Antriebseinheit (2),
   - Kompensieren (S5) des gemessenen zeitlichen Verlaufs des Magnetfelds (303) anhand des funktionalen Zusammenhangs sowie der zumindest einen gemessenen Betriebsgröße der Antriebseinheit (2).
   - Ermitteln (S6) der Geschwindigkeit des Fahrzeugs (1) anhand des kompensierten zeitlichen Verlaufs (305) des Magnetfelds.

2. Verfahren gemäß Anspruch 1, wobei der funktionale Zusammenhang ermittelt wird, indem zumindest ein Kennfeld des Störmagnetfelds (304) und der Betriebsgrößen der Antriebseinheit (2) wie der Stromstärke der Antriebseinheit (2) und/oder der Drehzahl der Antriebseinheit (2) erzeugt wird.

3. Verfahren gemäß Anspruch 2, wobei zumindest eine Funktion bestimmt wird, die das Kennfeld angenähert beschreibt.

4. Verfahren gemäß einem der Ansprüche 1-3, wobei Informationen des ermittelten funktionalen Zusammenhangs, insbesondere die zumindest eine Funktion und/oder das zumindest eine Kennfeld, in der Antriebseinheit (2) gespeichert werden.

5. Verfahren gemäß einem der Ansprüche 1-4, wobei der funktionale Zusammenhang einer Amplitude (306) des Störmagnetfelds (304) und/oder einer Phase des Störmagnetfelds (304) mit einer Stromstärke der Antriebseinheit (2) und/oder einer Drehzahl der Antriebseinheit (2) bestimmt wird.

6. Verfahren gemäß einem der Ansprüche 1-5, wobei der funktionale Zusammenhang, insbesondere in Form einer Funktion und/oder einem Kennfeld, bestimmt wird, während die Antriebseinheit (2) in einem Fahrzeug (1) betrieben wird.

7. Verfahren gemäß einem der Ansprüche 1-5, wobei der funktionale Zusammenhang, insbesondere in Form einer Funktion und/oder einem Kennfeld, bestimmt wird, während die Antriebseinheit (2) außerhalb eines Fahrzeugs (1) betrieben wird.

8. Verfahren gemäß einem der vorhergehenden Ansprüche, wobei das Kompensieren (S5) des gemessenen zeitlichen Verlaufs (303) des Magnetfelds anhand einer Rotorlage der Antriebseinheit (2) erfolgt.

9. Verfahren gemäß Anspruch 8, wobei das Ermitteln (S6) der Geschwindigkeit ein Erkennen einer Flanke (508) im zeitlichen Verlauf des gemessenen Magnetfelds (303, 305) umfasst.

10. Verfahren gemäß Anspruch 9, wobei das Erkennen einer Flanke (508) die Schritte umfasst:

    - Ermitteln von Hoch- und Tiefpunkten (503, 504) im zeitlichen Verlauf des Magnetfelds,
    - Ermitteln einer Flanke (508) anhand der zeitlichen Abfolge eines Hoch- und Tiefpunkts (503, 504), und

- Vergleichen der Amplitude (507) der ermittelten Flanke (508) mit zumindest einem Schwellwert (505), wobei die ermittelte Flanke (508) als erkannt gilt, wenn die Amplitude (507) der ermittelten Flanke (508) größer ist als ein erster kleinerer Schwellwert (505) und/oder größer ist als ein zweiter grö-ßerer adaptiver Schwellwert (506).

11. Verfahren gemäß einem der Ansprüche 9-10, wobei vor dem Erkennen der Flanke (508) die Werte des gemessenen Magnetfelds (303, 305) aufbereitet, insbesondere gefiltert, werden, vorzugsweise mittels eines Bandpassfilters, wobei insbesondere ein Sperr- und Durchlassbereich des Bandpassfilters an eine vorgegebene Umdrehungsfrequenz des Rades des Fahrzeugs (1) anpasst wird.

12. Verfahren gemäß einem der Ansprüche 9-11, wobei bei Erkennen einer Flanke (508) ein Zeitstempel erzeugt wird und/oder ein Zähler erhöht wird.

13. Verfahren gemäß einem der Ansprüche 9-12, wobei das Magnetfeld in mindestens zwei Raumrichtungen (12, 13) gemessen wird und wobei die in mindestens zwei Raumrichtungen (12, 13) gemessenen Werte des Magnetfeldes (303, 305) vor dem Erkennen einer Flanke (508) in eine Hauptachse (14) der Magnetfelder rotiert werden, insbesondere wobei der Winkel (15) der Hauptachse (14) für die Rotation anhand von Werten des Magnetfeldes (303, 305) in einer zweiten Raumrichtung (13) bestimmt wird.

14. Verfahren gemäß einem der Ansprüche 9-13, wobei zusätzlich ein zeitlicher Verlauf eines Vektors des Magnetfelds (303, 305) zur Auswertung der steigenden und/oder fallenden Flanken (508) ausgewertet wird, insbesondere zu deren Plausibilisierung.

15. Verfahren gemäß einem der Ansprüche 9-14, wobei anhand der ermittelten Flanke (508) eine mögliche Geschwindigkeit berechnet wird und wobei die Flanke (508) anhand zumindest eine der folgenden Bedingungen mittels eines Plausibilisierungsverfahrens plausibilisiert wird:

    - Wenn die mögliche Geschwindigkeit oberhalb eines vorgebbaren Schwellwerts liegt, wird die ermittelte Flanke (508) verworfen.
    - Wenn der Gradient der ermittelten Flanke (508) unterhalb eines Schwellwerts liegt, wird die ermittelte Flanke (508) verworfen.
    - Wenn die Zeitdifferenz zwischen dem Tiefpunkt (503) der ermittelten Flanke (508) und dem Zeitpunkt des Überschreitens eines Schwellwerts (505) in dem Flankenverlauf oberhalb eines vorgebbaren Schwellwerts ist, wird die ermittelte Flanke (508) verworfen.
    - Wenn die Fahrzeugbeschleunigungen, berechnet aus einer aktuell ermittelten Flanke (508) und einer früheren Flanke, oberhalb eines vorgebbaren Schwellwerts liegen, wird die aktuell ermittelte Flanke (508) verworfen.

16. Verfahren gemäß Anspruch 15, wobei das Plausibilisierungsverfahren eine Flankenvorhersage, insbesondere anhand von Beschleunigungsdaten des Fahrzeugs (1), umfasst, sodass eine erkannte Flanke (508) als unplausibel verworfen wird, wenn anhand der Beschleunigungsdaten keine Flanke (508) vorhergesagt wird.

17. Verfahren gemäß einem der Ansprüche 9-16, wobei zur Erkennung der Polarisierung des Magneten (5) eine vorgebbare Anzahl von ermittelten Flanken (508) und insbesondere ein Winkelverlauf des Magnetfeldvektors ermittelt wird, wobei die Polarisierung anhand eines Vergleichs von maximaler Amplitude (507) der steigenden und der fallenden Amplitude ermittelt wird, wobei wenn die maximale fallende Amplitude größer ist als die maximale steigende Amplitude die Polarisierung des Magneten (5) umgekehrt angenommen wird und die gemessenen Werte des Magnetfelds invertiert werden, wobei die Polarisierung insbesondere anhand einer vorgebbaren Anzahl von steigenden und/oder fallenden Flanken (508) ausgewertet wird.

18. Einspuriges Fahrzeug (1) wie ein Pedelec, wobei das Fahrzeug (1) eine elektrische Antriebseinheit (2), einen Magnetfeldsensor (3) und einen an einem Rad (4) des Fahrzeugs (1) angeordneten Magneten (5) aufweist, wobei der Magnetfeldsensor dazu eingerichtet ist, das Magnetfeld des Magneten bei Vorbeirotieren am Magnetfeldsensor zu detektieren, und wobei das Fahrzeug **gekennzeichnet ist durch**:

    - eine Steuereinrichtung (6), ausgebildet zum Betreiben der elektrischen Antriebseinheit (2) des Fahrzeugs (1) in mehreren Lastpunkten **durch** Verändern zumindest einer Betriebsgröße wie Stromstärke und/oder Drehzahl,
    - eine erste Ermittlungseinrichtung (8), ausgebildet zum Ermitteln eines funktionalen Zusammenhangs eines bestimmten Störmagnetfeldes (304) mit der zumindest einen Betriebsgröße,
    - eine Messeinrichtung, umfassend den Magnetfeldsensor, welche zum Messen eines zeitlichen Verlaufs eines Magnetfelds (303) mittels des Magnetfeldsensors (3) sowie von der zumindest einen Betriebsgröße der Antriebseinheit (2) wie einer Stromstärke der Antriebseinheit (2) und/oder einer Drehzahl der Antriebseinheit (2) ausgebildet ist,

- eine Kompensiereinrichtung (10), ausgebildet zum Kompensieren des gemessenen zeitlichen Verlaufs des Magnetfelds anhand des funktionalen Zusammenhangs sowie der zumindest einen gemessenen Betriebsgröße der Antriebseinheit (2),

- eine zweite Ermittlungseinrichtung (11), ausgebildet zum Ermitteln der Geschwindigkeit des Fahrzeugs (1) anhand des kompensierten zeitlichen Verlaufs (305) des Magnetfelds und insbesondere

- eine Bestimmungseinrichtung (7), ausgebildet zum Bestimmen des von der Antriebseinheit (2) erzeugten Störmagnetfelds (304), insbesondere eines durch einen Stator der Antriebseinheit (2) erzeugten Störmagnetfelds (304), in den mehreren Lastpunkten.

19. Fahrzeug (1) gemäß Anspruch 18, wobei die erste Ermittlungseinrichtung (8) dazu ausgebildet ist, den funktionalen Zusammenhang aus einem Speicher des Fahrzeugs (1), insbesondere einem Speicher der Antriebseinheit (2), zu ermitteln.

**Claims**

1. Method for determining a velocity of a single-track vehicle (1) such as a pedelec, wherein the vehicle (1) has an electric drive unit (2), a magnetic field sensor (3), and a magnet (5) arranged on a wheel (4) of the vehicle (1), wherein the magnetic field sensor is configured to detect the magnetic field of the magnet as it rotates past the magnetic field sensor, the method being **characterized by** the following steps:

   - operating (S1) the electric drive unit (2) at multiple load points by changing at least one operating variable such as current and/or speed,
   - determining (S2) a magnetic interference field (304) generated by the drive unit (2), in particular a magnetic interference field (304) generated by a stator of the drive unit (2), at the multiple load points,
   - ascertaining (S3) a functional relationship between the determined magnetic interference field (304) and the at least one operating variable of the drive unit (2),
   - measuring (S4) a time evolution of a magnetic field (303) by means of the magnetic field sensor (3) and of the at least one operating variable of the drive unit (2),
   - compensating (S5) for the measured time evolution of the magnetic field (303) based on the functional relationship and the at least one measured operating variable of the drive unit (2),
   - ascertaining (S6) the velocity of the vehicle (1) based on the compensated time evolution (305) of the magnetic field.

2. Method according to Claim 1, wherein the functional relationship is ascertained by virtue of at least one characteristic map of the magnetic interference field (304) and the operating variables of the drive unit (2), such as the current of the drive unit (2) and/or the speed of the drive unit (2), being generated.

3. Method according to Claim 2, wherein at least one function which approximately describes the characteristic map is determined.

4. Method according to any one of Claims 1-3, wherein information relating to the ascertained functional relationship, in particular the at least one function and/or the at least one characteristic map, are stored in the drive unit (2).

5. Method according to any one of Claims 1-4, wherein the functional relationship between an amplitude (306) of the magnetic interference field (304) and/or a phase of the magnetic interference field (304) and a current of the drive unit (2) and/or a speed of the drive unit (2) is determined.

6. Method according to any one of Claims 1-5, wherein the functional relationship, in particular in the form of a function and/or a characteristic map, is determined while the drive unit (2) is operated in a vehicle (1).

7. Method according to any one of Claims 1-5, wherein the functional relationship, in particular in the form of a function and/or a characteristic map, is determined while the drive unit (2) is operated outside a vehicle (1).

8. Method according to any one of the preceding claims, wherein the measured time evolution (303) of the magnetic field is compensated for (S5) based on a rotor position of the drive unit (2).

9. Method according to Claim 8, wherein the ascertaining (S6) of the velocity includes identification of an edge (508) in the time evolution of the measured magnetic field (303, 305).

10. Method according to Claim 9, wherein the identification of an edge (508) includes the steps of:

   - ascertaining high and low points (503, 504) in the time evolution of the magnetic field,
   - ascertaining an edge (508) based on the time sequence of a high point and low point (503, 504), and
   - comparing the amplitude (507) of the ascertained edge (508) with at least one threshold value (505), with the determined edge (508) being considered to be identified if the amplitude (507) of the ascertained edge (508) is greater than a first lower threshold value (505) and/or greater than a second larger adaptive threshold value (506).

11. Method according to any one of Claims 9-10, wherein the values of the measured magnetic field (303, 305) are processed, in particular filtered, preferably by means of a bandpass filter, before the identification of the edge (508), wherein, in particular, a stopband and passband of the bandpass filter is adapted to a predefined rotational frequency of the wheel of the vehicle (1).

12. Method according to any one of Claims 9-11, wherein a time stamp is generated and/or a counter is increased when an edge (508) is identified.

13. Method according to any one of Claims 9-12, wherein the magnetic field is measured in at least two spatial directions (12, 13) and wherein the values of the magnetic field (303, 305) measured in at least two spatial directions (12, 13) are rotated in a main axis (14) of the magnetic fields before the identification of an edge (508), in particular wherein the angle (15) of the main axis (14) for rotation is determined based on values of the magnetic field (303, 305) in a second spatial direction (13).

14. Method according to any one of Claims 9-13, wherein a time evolution of a vector of the magnetic field (303, 305) is additionally evaluated for the evaluation of the rising and/or falling edges (508), in particular for verifying the plausibility thereof.

15. Method according to any one of Claims 9-14, wherein a possible velocity is calculated based on the ascertained edge (508) and wherein the plausibility of the edge (508) is verified based on at least one of the following conditions by means of a plausibility verification method:

    - the ascertained edge (508) is rejected if the possible velocity is above a predeterminable threshold value,
    - the ascertained edge (508) is rejected if the gradient of the ascertained edge (508) is below a threshold value,
    - the ascertained edge (508) is rejected if the time difference between the low point (503) of the ascertained edge (508) and the time when a threshold value (505) in the evolution of the edge is exceeded is above a predeterminable threshold value,
    - the currently ascertained edge (508) is rejected if the vehicle accelerations, calculated from a currently ascertained edge (508) and an earlier edge, are above a predeterminable threshold value.

16. Method according to Claim 15, wherein the plausibility verification method comprises an edge prediction, in particular based on acceleration data relating to the vehicle (1), such that an identified edge (508) is rejected as implausible if no edge (508) is predicted based on the acceleration data.

17. Method according to any one of Claims 9-16, wherein a predeterminable number of ascertained edges (508) and, in particular, an angle evolution of the magnetic field vector are ascertained for the purpose of identifying the polarization of the magnet (5), with the polarization being determined based on a comparison of maximum amplitude (507) of the rising and falling amplitudes, with the polarization of the magnet (5) being assumed to be reversed and the measured values of the magnetic field being inverted if the maximum falling amplitude is greater than the maximum rising amplitude, with the polarization being evaluated, in particular, based on a predeterminable number of rising and/or falling edges (508).

18. Single-track vehicle (1), such as a pedelec, wherein the vehicle (1) has an electric drive unit (2), a magnetic field sensor (3), and a magnet (5) arranged on a wheel (4) of the vehicle (1), wherein the magnetic field sensor is configured to detect the magnetic field of the magnet as it rotates past the magnetic field sensor, and wherein the vehicle is **characterized by**:

    - a control device (6), designed to operate the electric drive unit (2) of the vehicle (1) at multiple load points by changing at least one operating variable, such as current and/or speed,
    - a first ascertaining device (8), designed to ascertain a functional relationship between a determined magnetic interference field (304) and the at least one operating variable,
    - a measuring device comprising the magnetic field sensor, which is designed to measure a time evolution of a magnetic field (303) by means of the magnetic field sensor (3) and of the at least one operating variable of the drive unit (2) such as a current of the drive unit (2) and/or a speed of the drive unit (2),
    - a compensating device (10) designed to compensate for the measured time evolution of the magnetic field based on the functional relationship and the at least one measured operating variable of the drive unit (2),
    - a second ascertaining device (11), designed to ascertain the velocity of the vehicle (1) based on the compensated time evolution (305) of the magnetic field and, in particular,

- a determining device (7), designed to determine the magnetic interference field (304) generated by the drive unit (2), in particular a magnetic interference field (304) generated by a stator of the drive unit (2), at the multiple load points.

19. Vehicle (1) according to Claim 18, wherein the first ascertaining device (8) is designed to ascertain the functional relationship from a memory of the vehicle (1), in particular a memory of the drive unit (2).

## Revendications

1. Procédé de détermination d'une vitesse d'un véhicule à voie unique (1) tel qu'un vélo à assistance électrique, le véhicule (1) comportant une unité d'entraînement électrique (2), un capteur de champ magnétique (3) et un aimant (5) monté sur une roue (4) du véhicule (1), le capteur de champ magnétique étant conçu pour détecter le champ magnétique de l'aimant lorsqu'il tourne en passant devant le capteur de champ magnétique, le procédé étant **caractérisée par** les étapes suivantes :

   - le fonctionnement(S1) de l'unité d'entraînement électrique (2) en plusieurs points de charge, par modification d'au moins une grandeur de fonctionnement telle que l'intensité du courant et/ou la vitesse de rotation,
   - la détermination (S2) d'un champ magnétique parasite (304) généré par l'unité d'entraînement (2), en particulier d'un champ magnétique parasite (304) généré par un stator de l'unité d'entraînement (2), au niveau de la pluralité de points de charge,
   - la détermination (S3) d'une relation fonctionnelle entre le champ magnétique parasite (304) déterminé et au moins une grandeur de fonctionnement de l'unité d'entraînement (2),
   - la mesure (S4) d'une variation dans le temps d'un champ magnétique (303) au moyen du capteur de champ magnétique (3) et de ladite au moins une grandeur de fonctionnement de l'unité d'entraînement (2),
   - la compensation (S5) de la variation dans le temps mesurée du champ magnétique (303) à l'aide de la relation fonctionnelle et de ladite au moins une grandeur de fonctionnement mesurée de l'unité d'entraînement (2),
   - la détermination (S6) d'une vitesse du véhicule (1) à l'aide de la variation dans le temps compensée (305) du champ magnétique.

2. Procédé selon la revendication 1, la relation fonctionnelle étant déterminée en générant au moins un diagramme caractéristique du champ magnétique parasite (304) et des grandeurs de fonctionnement de l'unité d'entraînement (2), telles que l'intensité du courant de l'unité d'entraînement (2) et/ou la vitesse de rotation de l'unité d'entraînement (2).

3. Procédé selon la revendication 2, au moins une fonction qui décrit approximativement le diagramme caractéristique étant déterminée.

4. Procédé selon l'une des revendications 1 à 3, des informations concernant la relation fonctionnelle déterminée, en particulier ladite au moins une fonction et/ou ledit au moins un diagramme caractéristique, étant mémorisés dans l'unité d'entraînement (2).

5. Procédé selon l'une des revendications 1 à 4, la relation fonctionnelle entre une amplitude (306) du champ magnétique parasite (304) et/ou une phase du champ magnétique parasite (304) et une intensité de courant de l'unité d'entraînement (2) et/ou une vitesse de rotation de l'unité d'entraînement (2) étant déterminée.

6. Procédé selon l'une des revendications 1 à 5, la relation fonctionnelle, en particulier sous la forme d'une fonction et/ou d'un diagramme caractéristique, étant déterminée pendant le fonctionnement de l'unité d'entraînement (2) dans un véhicule (1).

7. Procédé selon l'une des revendications 1 à 5, la relation fonctionnelle, en particulier sous la forme d'une fonction et/ou d'un diagramme caractéristique, étant déterminée pendant que l'unité d'entraînement (2) fonctionne à l'extérieur d'un véhicule (1).

8. Procédé selon l'une des revendications précédentes, la compensation (S5) de la variation dans le temps mesurée (303) du champ magnétique étant effectuée à l'aide d'une position de rotor de l'unité d'entraînement (2).

9. Procédé selon la revendication 8, la détermination (S6) d'une vitesse comprenant la détection d'un front (508) dans la variation dans le temps du champ magnétique mesuré (303, 305).

10. Procédé selon la revendication 9, la détection d'un front (508) comprenant les étapes suivantes :

   - la détermination de points haut et bas (503, 504) dans la variation dans le temps du champ magnétique,
   - la détermination d'un front (508) descendant ou montant à l'aide de la séquence temporelle d'un point haut et d'un point bas (503, 504), et
   - la comparaison de l'amplitude (507) du front (508) déterminé avec au moins une valeur de seuil (505), le front (508) déterminé étant considéré comme identifié lorsque l'amplitude (507) du front (508) déterminé est supérieure à une première valeur de seuil (505) inférieure et/ou est supérieure à une deuxième valeur de seuil (506) adaptative supérieure.

11. Procédé selon l'une des revendications 9 à 10, les valeurs du champ magnétique mesuré (303, 305) étant préparées, en particulier filtrées, avant l'identification du front (508), de préférence au moyen d'un filtre passe-bande, une bande de rejet et une bande passante du filtre passe-bande étant en particulier adaptées à une fréquence de rotation prédéfinie de la roue du véhicule (1).

12. Procédé selon l'une des revendications 9 à 11, un marqueur temporel étant généré et/ou un compteur étant incrémenté lorsqu'un front (508) est détecté.

13. Procédé selon l'une des revendications 9 à 12, le champ magnétique étant mesuré dans au moins deux directions spatiales (12, 13) et les valeurs du champ magnétique (303, 305) mesurées dans au moins deux directions spatiales (12, 13) étant soumises à une rotation des champs magnétiques avant l'identification d'un front (508) sur un axe principal (14), l'angle (15) de l'axe principal (14) étant en particulier déterminé pour la rotation dans une deuxième direction spatiale (13) à l'aide de valeurs du champ magnétique (303, 305).

14. Procédé selon l'une des revendications 9 à 13, la variation dans le temps du vecteur du champ magnétique (303, 305) étant en outre évaluée pour l'évaluation des fronts (508) montants et/ou descendants, en particulier pour le contrôle de leur plausibilité.

15. Procédé selon l'une des revendications 9 à 14, une vitesse possible étant calculée à l'aide du front (508) déterminé et la plausibilité du front (508) étant contrôlée à l'aide d'un procédé de contrôle de plausibilité au moyen d'au moins l'une des conditions suivantes :

   - si la vitesse possible est supérieure à une valeur de seuil pouvant être prédéfinie, le front (508) déterminé est rejeté.
   - si le gradient du front (508) déterminé est inférieur à une valeur de seuil, le front (508) déterminé est rejeté.
   - si la différence de temps entre le point bas (503) du front (508) déterminé et le moment du dépassement d'une valeur de seuil (505) dans le profil de front au-dessus d'une valeur de seuil pouvant être prédéfinie, le front (508) déterminé est rejeté.

   - si les accélérations de véhicule, calculées à partir d'un front (508) déterminé actuel et d'un front antérieur, sont supérieures à une valeur de seuil pouvant être prédéfinie, le front (508) déterminé est rejeté.

16. Procédé selon la revendication 15, le procédé de contrôle de plausibilité comprenant une prédiction de front, en particulier à l'aide de données d'accélération du véhicule (1), si bien qu'un front (508) identifié est rejeté comme non plausible si aucun front (508) n'est prédit à l'aide des données d'accélération.

17. Procédé selon l'une des revendications 9 à 16, un nombre pouvant être prédéfini de fronts (508) déterminés et en particulier un profil angulaire du vecteur de champ magnétique étant déterminés pour identifier la polarisation de l'aimant (5), la polarisation étant déterminée à l'aide d'une comparaison de l'amplitude maximale (507) de l'amplitude montante et de l'amplitude descendante, la polarisation de l'aimant (5) étant supposée inversée et les valeurs mesurées étant inversées lorsque l'amplitude descendante maximale est supérieure à l'amplitude montante maximale, la polarisation étant en particulier évaluée à l'aide d'un nombre pouvant être prédéfini de fronts (508) montants et/ou descendants.

18. Véhicule (1) à voie unique tel qu'un vélo à assistance électrique,
le véhicule (1) comportant une unité d'entraînement électrique (2), un capteur de champ magnétique (3) et un aimant (5) montés sur une roue (4) du véhicule (1), le capteur de champ magnétique étant conçu pour détecter le champ magnétique de l'aimant lorsqu'il tourne en passant devant le capteur de champ magnétique, et le véhicule étant **caractérisé par** :

   - un dispositif de commande (6), conçu pour faire fonctionner l'unité d'entraînement électrique (2) du véhicule (1) en plusieurs points de charge, par modification d'au moins une grandeur de fonctionnement telle que l'intensité du courant et/ou la vitesse de rotation,
   - un premier dispositif de détermination (8), conçu pour déterminer une relation fonctionnelle entre un champ magnétique parasite (304) déterminé et ladite au moins une grandeur de fonctionnement,
   - un dispositif de mesure, comprenant le capteur de champ magnétique, qui est conçu pour mesurer une variation dans le temps d'un champ magnétique (303) au moyen du capteur de champ magnétique (3) et d'au moins une grandeur de fonctionnement de l'unité d'entraînement (2) telle qu'une intensité de courant de l'unité d'entraînement (2) et/ou une vitesse de rotation de l'unité d'entraînement (2),
- un dispositif de compensation (10), conçu pour compenser la variation dans le temps mesurée du champ magnétique à l'aide de la relation fonctionnelle et de la grandeur de fonctionnement mesurée de l'unité d'entraînement (2),
- un deuxième dispositif de détermination (11), conçu pour déterminer la vitesse du véhicule (1) à l'aide de la variation dans le temps compensée (305) du champ magnétique et en particulier,
- un dispositif de détermination (7), conçu pour déterminer le champ magnétique parasite (304) généré par l'unité d'entraînement (2), en particulier un champ magnétique parasite (304) généré par un stator de l'unité d'entraînement (2), au niveau de la pluralité de points de charge.

19. Véhicule (1) selon la revendication 18, dans lequel le premier dispositif de détermination (8) est conçu pour déterminer la relation fonctionnelle à partir d'une mémoire du véhicule (1), en particulier d'une mémoire de l'unité d'entraînement (2).

S1

↓

S2

↓

S3

↓

S4

↓

S5

↓

S6

**Fig. 1**

S1'

↓

S2'

↓

S3'

↓

S4'

↓

S5'

**Fig. 2**

Fig. 3

EP 4 388 325 B1

Fig. 4

EP 4 388 325 B1

Fig. 5

EP 4 388 325 B1

Fig. 6

Fig. 7

EP 4 388 325 B1

**IN DER BESCHREIBUNG AUFGEFÜHRTE DOKUMENTE**

**In der Beschreibung aufgeführte Patentdokumente**

- DE 102017210673 A1
- EP 3435094 A2
- US 2019353677 A1